# EUROPEAN PATENT APPLICATION

(11) **EP 3 451 538 A1**
(43) Date of publication of application: **06.03.2019**
(21) Application number: 17188480.2
(22) Date of filing: 30.08.2017
(51) Int. Cl.: H03M 7/30

(54) **METHOD AND DEVICE FOR HANDLING SENSOR MEASUREMENT DATA**

(71) Applicant: Melexis Technologies SA, 2022 Bevaix (CH)
(72) Inventor: OTT, Andreas, 99099 Erfurt (DE)
(74) Representative: DenK iP

(57) **Abstract**

The present invention relates to a method for reducing an amount of measurement data, comprising :
- receiving a set of measurement data values of a physical quantity,
- for a first data value of said set checking if said first data value meets a condition for storing and if said condition for storing is met, storing said first data value in a memory,
- for each subsequent data value of said set, storing said subsequent data value as long as a condition for continued storage is met,
- performing a postprocessing operation on the data values stored in said memory,
- storing the postprocessed data values.

## Description

### Field of the invention

The present invention is generally related to the field of compressing measurement data obtained from a sensor in a sensor network.

### Background of the invention

Modern vehicles include many systems, sub-systems, actuators, sensors, etc. that provide measurement data that is transferred between various systems and sub-systems on the vehicle that allow the vehicle to operate in a desired manner. Typically, the data is transferred between the systems and sub-systems on one or more data busses, sometimes referred to as a controller area network (CAN) data bus or a Local Interconnect Network (LIN) bus. When a vehicle is being serviced, tested, developed, etc., the measurement data on e.g. the CAN bus is typically transferred to testing equipment and the like separate from the vehicle. It is necessary that this data be stored in a storage device, from which it is then subsequently analysed. However, a problem exists because the amount of data produced by the vehicle over a certain period of time can be very large, requiring a very large storage device, which increases cost. This example from the automotive industry is only one illustration of the numerous applications, where there is a strong need to collect, interpret and act on real-time data.

Often sensor networks, wired or wireless, are used to collect the data. The huge chunk of data provided by the sensors in the sensor network, are post-processed in a central unit, which acts as a master node in the sensor network. This central unit analyses and processes the data received from the sensor nodes in a transparent way and extracts relevant information out of it to decide on appropriate actions to be taken.

The physical quantity to be sensed by the sensor is primarily uncorrelated to the update rate of the network. Therefore the network requires a certain amount of oversampling to be able to account for changes of the physical quantity to be sensed. The network traffic further increases as the number of subscribed sensor nodes increases. This puts a limit on the maximum number of sensors in the network as the bandwidth of the network itself is limited. Some of the information comprised in the measurement data provided by the sensor is later be discarded or removed in a central unit, e.g. in the master node in the sensor network as it might carry no information content anymore, e.g. a sensing input does not change over a given time period or the sensing signal is just too small to be interpreted. These measurement values occupy a certain amount of bandwidth from the communication network, but do not carry relevant information for a higher-level unit.

In order to reduce the amount of data, various solutions have already been proposed in the prior art. To reduce the required bandwidth for the sensor network, US2009/300039 discloses a method for compressing measurement data that includes grouping common data elements in common data messages. Measurement data is grouped together and a single element in that group is represented as the difference to its predecessor element. This reduces the bit width needed to represent the elements in case the measurement data are expected to change only slowly, resulting in small differences among the samples.

In EP3171553 a method for the transmission of data obtained from a control network is described. In the method, at least a portion of the data is compressed by means of at least one compression algorithm (e.g. Golomb-Rice coding) before at least the compressed part of the data is transmitted to a bus system.

In case the signal to be captured by the sensor is sparse (i.e., the information rate of the signal is much lower than its bandwidth suggests), compressed sampling can be employed to recover the signal from far fewer samples or measurements than the Nyquist-rate. For example, a typical signal acquisition application using compressed sampling can be found in the paper *"*A 9.8b-ENOB 5.5fJ/step fully-passive compressive sensing SAR ADC for WSN applications" (W. Guo et al., 42nd Eur. Solid-State Circuits Conf. ESSCIRC2016, Lausanne, 2016).

The sparsity of the signal to be captured might change during a specific measurement cycle or interval. In such a case, compressed sampling might not help since a sudden change in the signal to be captured becomes undersampled and might not be recoverable by the central processing unit. On the other hand, compressed encoding as in US2009/300039 and EP3171553 might still lead to a relatively high required bandwidth in the sensor network.

Another way to reduce the amount of data in order to limit memory space for storage or to limit the required throughput for communicating sensor readings over a network can be found in US7028546B2. Herein a programmable fixed threshold is used to be compared with an angular rate sensor reading. The sensor readings are stored sample after sample to the same memory location and if the angular rate exceeds a certain threshold, the memory location is updated with the momentary time stamp as long as a timeout is reached or the angular rate has fallen below the threshold. Afterwards the address pointer to the memory location is changed to point to the next block in the memory and the measurement iteration starts again. A limitation of this approach is that only the raw measured values are stored and available for further processing.

Hence, there is a need for a solution wherein the amount of measurement data to be stored is efficiently reduced while still allowing for the derivation of useful information by further processing of the stored data.

### Summary of the invention

It is an object of embodiments of the present invention to provide for a method to reduce the huge amount of measurement data received from a sensor or sensor network.

The above objective is accomplished by the solution according to the present invention.

In a first aspect the invention relates to a method for reducing an amount of measurement data. The method comprises :
- receiving a set of measurement data values of a physical quantity,
- for a first data value of the set checking if said first data value meets a condition for storing and if the condition for storing is met, storing the first data value in a memory,
- for each subsequent data value of the set, storing the subsequent data value as long as a condition for continued storage is met,
- performing a postprocessing operation on the data values stored in the memory,
- storing the postprocessed data values.

The proposed solution indeed allows for a reduction of the amount of measurement data. Data storage only starts when a first data value of a received data set meets a condition for storing and lasts until for some later data value a condition for continued storage is not met anymore. Then postprocessing is performed on that stored data and the resulting postprocessed data values are stored as well. The received data values and the postprocessed data values can be stored on different locations of a same physical memory or on different physical memories, as the skilled person will readily understand. The received amount of measurement data is so replaced by a much more reduced amount of data comprising a subset of the original measurement data and some postprocessed data derived from said subset.

In an embodiment a calibration step is performed wherein the condition for storing and/or the condition for continued storage are programmed.

In another embodiment the condition for storing and/or the condition for continued storage are received via a network connection.

In a preferred embodiment the condition for storing is a threshold. The threshold is advantageously adaptable. In one embodiment the adaptable threshold is dependent on data values of the physical quantity or of another physical quantity.

In another embodiment the condition for storing is a maximum number of consecutive data values not having met the condition for storing.

In one embodiment the condition for continued storage indicates a fixed number of storable data values.

In one embodiment the postprocessing operation comprises deriving at least one mathematical characteristic of said data values stored in said memory.

Advantageously, the method comprises checking if a stop criterion is satisfied and if not, repeating the steps of the method as set out above.

In another embodiment the method comprises a step of reading out said postprocessed data values.

In one embodiment a signal conditioning is performed on the received set of measurement data values.

In a preferred embodiment the method further comprises
- receiving an additional set of measurement data values of an additional physical quantity,
- for a first data value of said additional set checking if said first data value meets an additional condition for storing and if said additional condition for storing is met, storing said first data value in a memory,
- for each subsequent data value of said additional set, storing said subsequent data value as long as an additional condition for continued storage is met,
- performing a postprocessing operation on the data values of said additional set stored in said memory,
- storing the postprocessed data values of said additional set.

In one embodiment said taking into account comprises a postprocessing on the corresponding data values of the additional set.

In a specific embodiment the additional condition for storing is the same as the condition for storing and/or wherein additional condition for continued storage is the same as the condition for continued storage.

In another aspect the invention relates to a device for reducing an amount of measurement data, comprising a data processing unit arranged for
- receiving a set of measurement data values of a physical quantity,
- checking for a first data value of said set if said first data value meets a condition for storing and, if said condition for storing is met, forwarding said first data value for storage in a memory,
- forwarding for each subsequent data value of said set, said subsequent data value for storage in said memory as long as a condition for continued storage is met,
- performing a postprocessing operation on the data values stored in said memory,
- storing the postprocessed data values.

In a preferred embodiment the device comprises a communication unit arranged for reading out the postprocessed data values and applying the read out data to a sensor network.

In an embodiment the communication unit is arranged to receive via a network connection said condition for storing and/or said condition for continued storage and to forward it to said data processing unit.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, wherein like reference numerals refer to like elements in the various figures.
Fig.1 illustrates an embodiment of a device according to the present invention.
Fig.2 illustrates a detailed flow chart of an embodiment of the method of the present invention.
Fig.3 illustrates a first example wherein the proposed method is applied.
Fig.4 illustrates which postprocessed data values are stored.
Fig.5 illustrates an embodiment of a device according to the invention.
Fig.6 illustrates a detailed flow chart of another embodiment of the invention.
Fig.7 illustrates a second example wherein the proposed method is applied.
Fig.8 illustrates an embodiment of the device according to the invention adapted for performing the second example.
Fig.9 illustrates a further embodiment of a device according to the invention.

### Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

The present invention relates to the efficient handling of sensor measurement data. This data originates from a sensor or a plurality of sensors forming a sensor network. The sensor network is connected, wired or wirelessly, to a device or system wherein the measured data is processed as detailed below. Alternatively, the sensors (and hence the sensor network) are an integrated part of the system. As set out in the background section, a huge amount of measurement data is output by the sensor network. The proposed solution aims to reduce that amount of data.

The invention may be useful in many application fields. Some examples are distance measurements and object detection using e.g. Sonar, Radar or Lidar. The time-of-flight in such an application is proportional to the distance between the sensor and the object(s) to be identified. Only the measured physical quantities are of interest to the processing system to qualify a real object, whereas the noise captured between the object responses is not of interest.

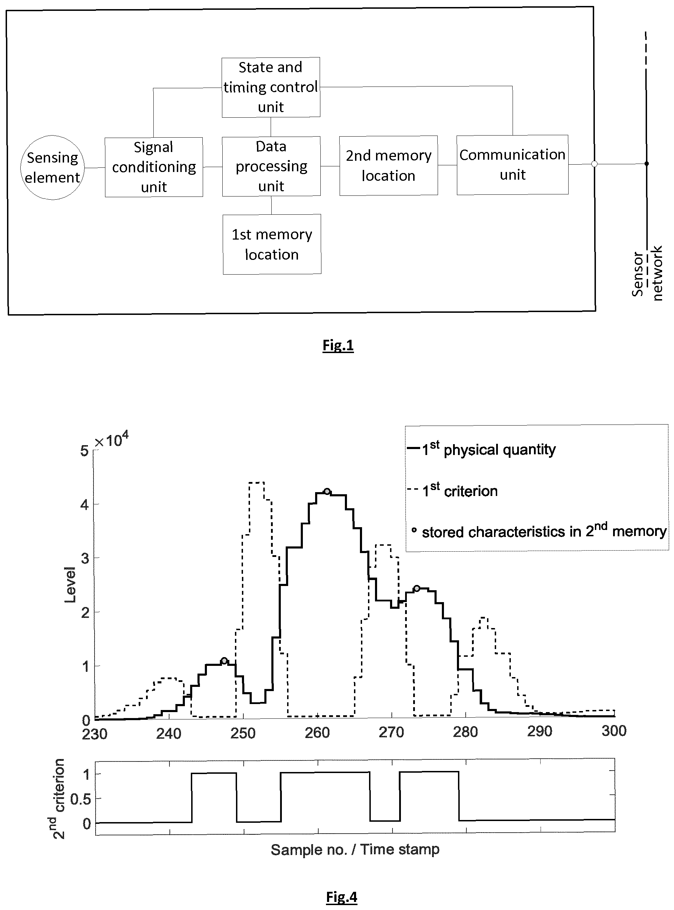

In an embodiment the solution of the invention comprises at least a data processing unit. In a preferred embodiment the system also comprises memory. The various components of the system are then integrated into a single device comprising at least a data processing block and preferably also storage means. Alternatively the memory is external to the device. The system or device usually also comprises a signal conditioning unit for magnifying, conditioning and/or converting the sensed signal obtained by the sensing element. However, in simple arrangements (e.g. a solar cell system) such a signal conditioning unit might not be needed. In an embodiment of the invention a state-and-timing control unit is provided to manage the measurement data storage and processing. In a preferred embodiment the system further comprises a communication unit arranged for reading out data and applying the read out data to a sensor network. An embodiment of a device according to the invention is illustrated in Fig.1, where the various optional blocks are shown along with the data processing block.

In a first aspect an approach is disclosed to reduce the amount of measurement data that needs to be stored. In an embodiment of the invention a sensor transmits measurement data values of a certain physical quantity (e.g. voltage, current, pressure, temperature, ...) to the device. In the data processing unit of the system a first received value is checked to see if it meets a first criterion. This first criterion is hereafter referred to as a 'condition for storing', as it sets a test to see if a data value is worthwhile to be stored. This test can e.g. be a comparison with a threshold. More examples of tests are provided later in this description. If the check yields a positive outcome, i.e. the first criterion is met, said first data value is stored in a memory. Subsequent received data values are stored as long as a second criterion is met. This second criterion is hereafter referred to as a condition for continued storage, as it determines how long subsequent data values are being stored. Hence, if checking this condition for continued storage yields a positive result, the subsequent measurement data value is actually stored in the memory. Data values are being written to the memory as long as the condition for continued storage is met.

The measurement data values stored in the memory are subsequently postprocessed in the data processing unit, whereby typically mathematical characteristics of the stored data values are derived. The resulting postprocessed data is stored, either on a different location in the same physical memory as used to store the sampled measurement data values or in a physically different memory.

The condition for storing and the condition for continued storage are adaptable. The user can program them. In one embodiment they can be stored in memory of the data processing unit. The memory can be e.g. a random-access memory (RAM) or a non-volatile memory as e.g. a read only memory (ROM) or a programmable non-volatile memory as e.g. an EEPROM or flash memory. In one embodiment the condition for storing and the condition of continued storage are programmed during a calibration step of the system. In another embodiment the condition for storing and the condition of continued storage are received through a network connection and adjusted according to the application needs.

The condition for storing used for checking the received measurement data values can for example be defined using one of the options in the following non-exhaustive list :
- a fixed set point, whereby it is simply checked if the data value reaches this fixed point or not,
- a pre-programmed threshold value or function, which depends on at least one other physical quantity such as voltage, current, time, temperature, pressure, concentration level, different from the first physical quantity,
- an adaptive threshold calculated on the various samples of the measured physical quantity itself,
- a maximum number of consecutive samples have not met the set condition. This can be seen as setting the maximal length of a time out interval,
- any combination of the previous options, e.g., applying the maximum or minimum among the variants used or combining them in a mathematical function.

As explained the measured data values of a physical quantity observed by the sensor, obtained at a given rate, are consecutively stored by the data processing unit to a first memory location upon a first data value reaching the condition for storing for as long as the condition for continued storage is fulfilled. This condition for continued storage can for example
- indicate a fixed number of samples that can be stored
- be met as long as the condition for storing described above is valid. Note that this boils down to performing a check on each sample to see if the condition for storing is met or not. In other words, the condition for continued storage then becomes the same as the condition for storing.
- be met as long as the condition for storing is valid, while meeting an additional restriction , e.g. that the condition for storing is met for at least a minimum amount of samples, or that a maximum applicable number of samples is not reached

Next a postprocessing of the stored data values is performed in the data processing unit, whereby one or more mathematical characteristics are derived from the stored measurement data. This can for example concern the determination of
a) one or more local maxima within the samples of the measured physical quantity and optionally the corresponding time stamp (e.g. the respective sample number),
b) one or more local minima within the samples of the physical quantity and optionally the corresponding time stamp (e.g. the respective sample number),
c) the width of said local maxima or minima, calculated as the number of samples within a fixed value relative to the local maxima or minima, respectively
d) the average or sum of the available samples of the physical quantity,
e) the time stamp of the first sample stored and optionally its value,
f) the time stamp of the last sample stored and optionally its value,
g) any above combination of options a) to f).
The so obtained information is stored in a memory location indicated e.g. by an address pointer. As already mentioned, this can be in a separate memory or in another location of the memory used for storing the data values. The data processing unit then changes the target location of the memory for the next set of data values to be stored, e.g. by incrementing the address pointer.

The system may further comprise a state-and-timing control unit. This functional block may comprise a break or stop criterion. The data processing unit then checks if said break or stop criterion (e.g. a time-out indicated by the state and timing control unit) is fulfilled. In case that criterion is not satisfied, the loop is restarted and a next amount of measurement data starts being processed. Otherwise the loop is stopped so that the sensor can enter another mode of operation issued by the state and time control unit.

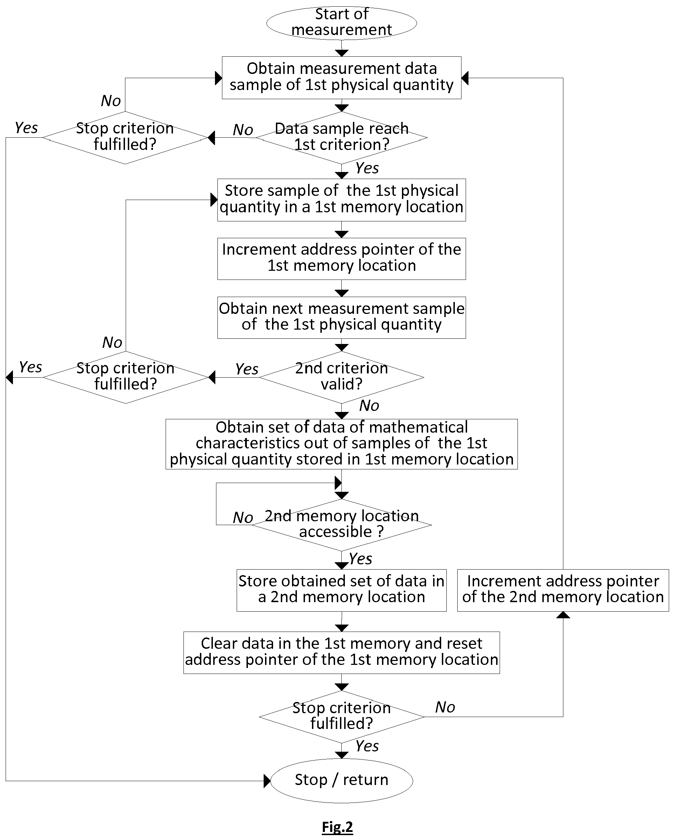

A detailed flow chart of one embodiment of the proposed method is shown in Fig.2. After initiating the measurement procedure, a first measurement data sample is obtained from the sensor and it is checked if it is reaching the first criterion (i.e. the condition for storing). In case the first measurement data sample is not compliant with the first criterion, the next measurement data sample is checked unless a stop criterion, e.g. a time-out, is reached. In case the sample meets the first criterion, the data sample is stored to a first memory location. Note that for the first sample the condition for continued storage is always met by default. An indicator of the first memory location is adapted, by e.g. incrementing an address pointer, and a next measurement is obtained and stored to the first memory location, sample after sample, as long as the criterion for continued storage is complied with and no stop criterion has been met.

In case the stop criterion is satisfied (while the criterion for continued storage is still fulfilled), the measurement session is stopped (or finalized). In case the criterion for continued storage is not met anymore, the data processing unit starts extracting mathematical characteristics from the samples of the measured physical quantity stored to the first memory location and writes the obtained mathematical characteristics to another memory location in the same or another physical memory. Since the latter memory location is readout by a communication unit provided in the device, it may happen that this memory location is busy so that the data processing unit needs to apply a wait cycle until the memory location becomes available. Once the obtained mathematical characteristics have been written into memory and if no stop criterion has been reached meanwhile, the memory location indicator is adapted, by e.g. incrementing the corresponding address pointer. Then it is checked for the next measurement sample if the condition for storing is fulfilled to find the next set of samples of the observed physical quantity to be stored in memory during the next iteration. This is repeated until a stop criterion is satisfied.

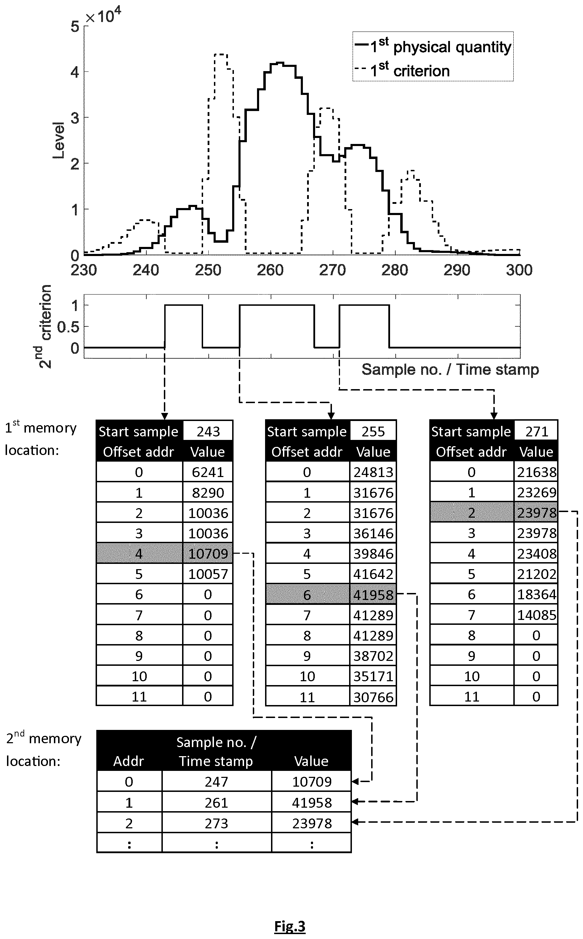

An illustrative example is given. Consider an envelope signal extracted from a sensor reading representing the physical quantity to be measured. In accordance with the described method, the envelope is compared with a condition for storing, e.g. an adaptive threshold which is calculated on the various measurement data samples of the physical quantity itself, highlighted as dashed waveform curve in Fig.3. Such a first criterion can be calculated using the methods well known in the art. The condition for continued storage is here so chosen that this criterion is valid as long as the condition for storing is satisfied. The criterion for continued storage used in this example is shown in the lower waveform of Fig.3, where a '0' or '1' indicates whether the criterion for continued storage is invalid or valid, respectively. Upon the first sample satisfying the condition for storing, the consecutive samples of the observed physical quantity are stored in a memory as long as the condition for continued storage is fulfilled. In this example the first writing operation to the memory starts with sample number (or, equivalently, time step) 243 and ends at sample number/time step 248. In order to save memory space, only the sample number of the starting sample is stored, whereas subsequent samples are stored at incremental positions in the memory location, denoted as offset address in the table. The table representing the memory location where the data values are stored shows only the first 12 samples for reasons of conciseness. A zero value means that this position is not used in the writing operations.

The obtained samples are mathematically characterized by searching the peak value among the available samples. These characteristics are sequentially written to a memory location. As a result, three peak positions are identified in this example at sample positions (time stamps) [247, 261, 273] with the respective peak values of [10709, 41958, 23978]. Fig.4 shows these peak positions, annotated on the waveform of the observed physical quantity. Instead of sending the 70 samples representing the waveform of the physical quantity shown in Fig.3 and Fig.4, the relevant information is reduced to three data sets of sample numbers/time stamps and the peak value. This gives a saving in necessary communication of more than 10 times the original rate. Moreover, by knowing the cascaded transfer function of the sensor and the subsequent data acquisition unit, a master device which has received the data sets from the memory location where the mathematical characteristics are stored, is able to reconstruct the original waveform with a high level of accuracy by a convolution of the three peak values with this cascaded transfer function.

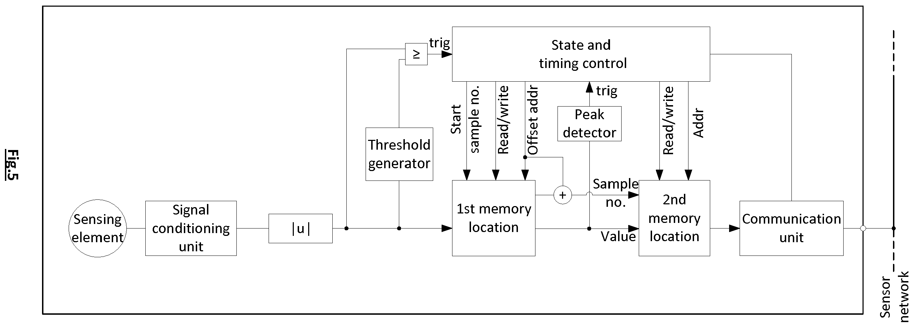

Fig.5 shows a possible implementation of a device adapted for use in the example elaborated above. The data processing unit is shown in some detail. After conditioning the signal obtained by the sensing element, the magnitude information of the physical quantity to be measured is first extracted by taking its absolute value. A comparator compares this absolute value with a threshold derived in a threshold generator from samples of the magnitude signal itself. If it is equal to or greater than the threshold, the comparator output indicates the criterion for storing is fulfilled and triggers the state and timing control unit according to the flowchart in Fig.2. As a result, the magnitude samples are stored in a first memory location as long as the second criterion is fulfilled. The second criterion, i.e. the one for continued storage, is evaluated in the state and timing control unit which also controls the memory access. Once the physical samples have been written to the first memory location, the state and control unit controls the memory access in such a way that the stored physical quantities are played back to the block obtaining the mathematical characteristics. In this example, this is done by using a peak detector. Once a local maximum or peak has been found, the state and timing control unit is triggered by the peak detector. This is indicating the memory position in the first memory location containing the data set to be transferred to the second memory position, composed of related sample number and value. In this particular case only the start sample number is stored in the first memory while the samples of the physical quantity are stored at incremental positions, the sample number to be stored in the second memory location is derived by summing the stored start sample number and the offset address provided by the state and timing control unit. The second memory location now hosts the peak values which can be accessed by the communication unit for transfer over the sensor network.

In a further embodiment the data processing unit receives at least one additional physical quantity from the sensor measurement data. This additional data allows qualifying the measured data further. As soon as a first data value of the first set of measurement data has met the first criterion and hence storage of the data values of the first set has started, the corresponding data values of the additional measurement data set are stored as well. The at least one additional physical quantity of the measurement data is thus stored simultaneously to the first physical quantity. The mathematical characteristics obtained for the first physical quantity are now complemented with corresponding sample(s) (i.e. obtained at the same time instant) of the at least one other physical quantity stored in memory. Such complementation can be done for example in one of the following ways :
- finding one or more local maxima within the samples of the measured physical quantities, obtaining all samples of physical quantities at the sample number and optionally the corresponding time stamp (e.g. the respective sample number),
- finding one or more local minima within the samples of the measured physical quantities, obtaining all samples of physical quantities at the sample number and optionally the corresponding time stamp (e.g. the respective sample number),
- the width of said local maxima or minima, calculated as the number of samples within a fixed value relative to the local maxima or minima, respectively
- the average or sum of the available samples of the physical quantities,
- obtaining the sample(s) of the at least one other physical quantity from the first memory location at the same sample number/time step position where the mathematical characteristics from the samples of the first physical quantity have been derived,
- obtaining the sample(s) of the at least one other physical quantity from the first memory location at the same sample number/time step position where the mathematical characteristics from the samples of the first physical quantity have been derived and find the maximum among the other physical quantities in case more than one additional physical quantity is stored in the first memory location, or
- obtaining the sample(s) of the at least one other physical quantity from the first memory location at the same sample number/time step position where the mathematical characteristics from the samples of the first physical quantity have been derived and find the minimum among the other physical quantities in case more than one additional physical quantity is stored in the first memory location, or
- obtaining the sample(s) of the at least one other physical quantity from the first memory location at the same sample number/time step position where the mathematical characteristics from the samples of the first physical quantity have been derived and find the maximum among the additional subset of physical quantities in case more than one additional physical quantity is stored in the first memory location and combine it with a corresponding physical quantity from another subset of additional physical quantities, or
- obtaining the sample(s) of the at least one other physical quantity out of the first memory location at the same sample number/time step position where the mathematical characteristics out of the samples of the first physical quantity have been derived and find the minimum among the an additional subset of physical quantities in case more than one additional physical quantity is stored in the first memory location and combine it with a corresponding physical quantity out of another subset of additional physical quantities, or
- the average(s) or sum(s) of the available samples of the at least one other physical quantity, or
- the maximum among the averages or sums of the available samples of the first at least one other physical quantity in case more than one additional physical quantity is stored in the first memory location, or
- the minimum among the averages or sums of the available samples of the first at least one other physical quantity in case more than one additional physical quantity is stored in the first memory location, or
- any above combination of the above-mentioned options

After the characterization of the physical quantities in the latter two steps has been accomplished, the data processing unit stores the obtained results in a second memory location. The target location in this memory space is indicated e.g. by an address pointer.

Next the target location for the next/upcoming set of data is changed, by e.g. an incrementing an address pointer.

It is then checked if any break or stop criterion is fulfilled, e.g. a time-out indicated by the state and timing control unit. In case such a criterion is not reached, the loop is restarted, otherwise the loop is stopped so that the sensor can enter another mode of operation issued by the state and time control unit.

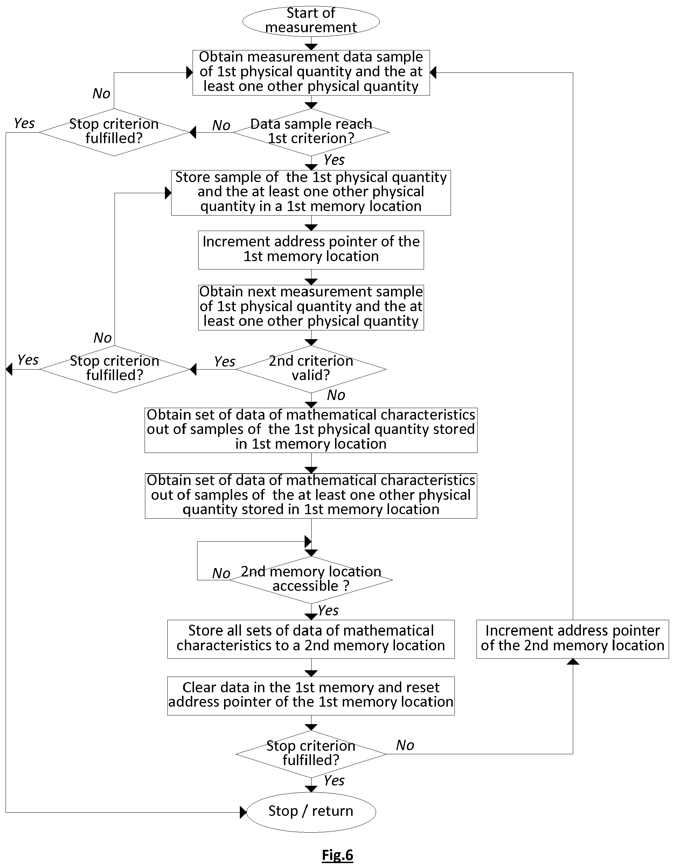

Fig.6 shows a detailed flow chart of an embodiment of the present invention as described above. After initiating the measurement procedure, a first measurement sample is obtained from the sensor and checked if it is reaching the first criterion, i.e. the condition for storing. In case the first measurement sample is not compliant with the first criterion, the next measurement sample is checked unless a stop criterion, e.g. a time-out, is reached. In case the sample meets the first criterion, the samples of all physical quantities required in the application are stored to a first memory location. An indicator for the first memory location is changed, e.g. by incrementing an address pointer, and a next measurement is obtained and stored in the first memory, sample after sample, as long as the condition for continued storage is complied with and no stop criterion has been met.

In case the stop criterion is satisfied, the measurement session is stopped (or finalized). In case the criterion for continued storage is not met anymore, the data processing unit starts extracting mathematical characteristics from the samples of the first physical quantity stored in the first memory location. Afterwards or simultaneously, the data processing unit starts extracting mathematical characteristics from the samples of the at least one other physical quantity as described above. Afterwards the data processing unit writes the obtained mathematical characteristics to a second memory location. Since the second memory location is readout by the communication unit, it may happen that the second memory is busy so that the data processing unit needs to apply a wait cycle until the second memory location becomes ready. Once the obtained mathematical characteristics have been written into memory and if no stop criterion has been reached meanwhile, the memory location indicator is adapted, by e.g. incrementing the address pointer. Then it is checked for the next measurement sample if the condition for storing is fulfilled to find the next set of samples of the first physical quantity to be stored in memory during the next iteration. This is repeated until a stop criterion is satisfied.

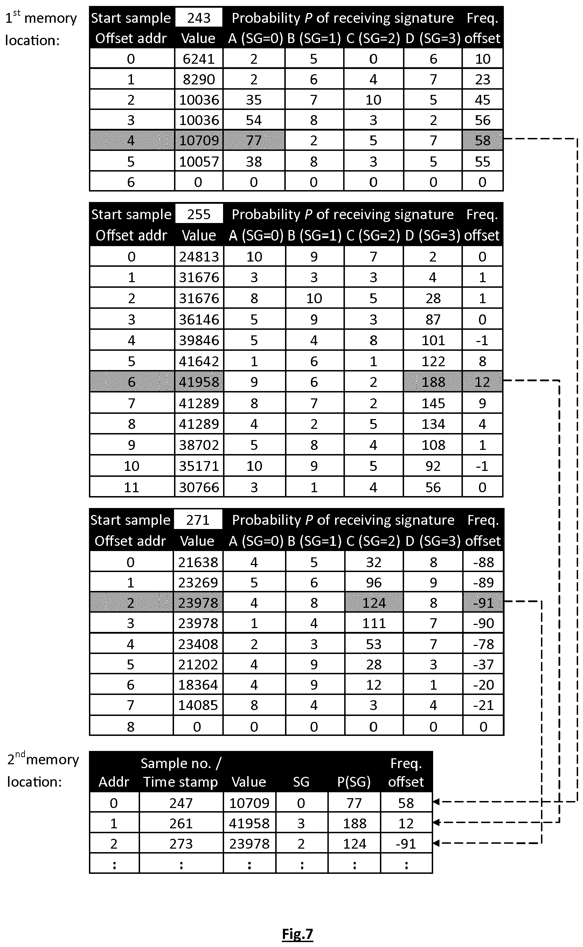

In a second example an envelope signal is extracted from a sensor reading representing the first physical quantity to be measured. In accordance with the described method, the envelope is compared with as a condition for storing an adaptive threshold which is calculated on the various samples of the first physical quantity itself, similar to the dashed waveform curve in Fig.3 from the first example. Such a condition for storing can be calculated using the methods known in the art. The condition for continued storage is here so chosen that this criterion is valid as long as the condition for storing is satisfied. The second criterion of the second example is shown in the lower waveform of Fig.3 in the first example; whereas a '0' or '1' indicates the condition for continued storage is invalid or valid. Upon reaching the first criterion, the samples of the first physical quantity and at least one other physical quantity are stored in a first memory location as long as the condition for continued storage is fulfilled. In this second example, shown in Fig.7, five additional quantities are stored to qualify the first physical quantity further. Four additional physical quantities are derived by the data processing unit which indicate the probability that the sensed waveform contains a signature of either A,B,C or D. The fifth additional quantity in this example is the frequency offset of the received waveform with respect to the local frequency inside the sensor. This is also derived in the data processing unit. The first writing process to the first memory location starts with sample number/time step 243 and ends at sample number/time step 248. In order to save memory space, only the start sample number of the starting sample is stored whereas the subsequent samples are stored at incremental positions in the memory location, denoted as offset address in the table. Without being limited to 12, the table representing the first memory location shows only the first 12 samples. A zero value means that this position is not used in the related writing process.

The obtained samples of the first physical quantity are mathematically characterized by searching the peak value among the available samples. The maximum among the probabilities P of signatures A,B,C and D is derived at the same sample number/time step position where the mathematical characteristics from the samples of the first physical quantity have been derived. At the same sample number/time step position the frequency offset is obtained. The data set representing the evaluated characteristics are sequentially written to the second memory location. In the second example the data set comprises
- Sample number/time stamp
- Peak value
- Signature SG containing the max. probability value
- Probability of SG
- Frequency offset

In this second example shown in Fig.7 three peak positions are identified at sample positions / time stamps [247, 261, 273] with the respective peak values of [10709, 41958, 23978] for the peak value, [0 3 2] for the most probable signatures, [77 188 124] for the level of confidence of the found signature and [58 12 -91] for the measured frequency offsets. Instead of sending the 70 samples representing the waveform of the first physical quantity and the waveforms of the additional physical quantities, the relevant information is reduced to three data sets only. This gives a saving in communication of more than 10 times the original rate in the given example.

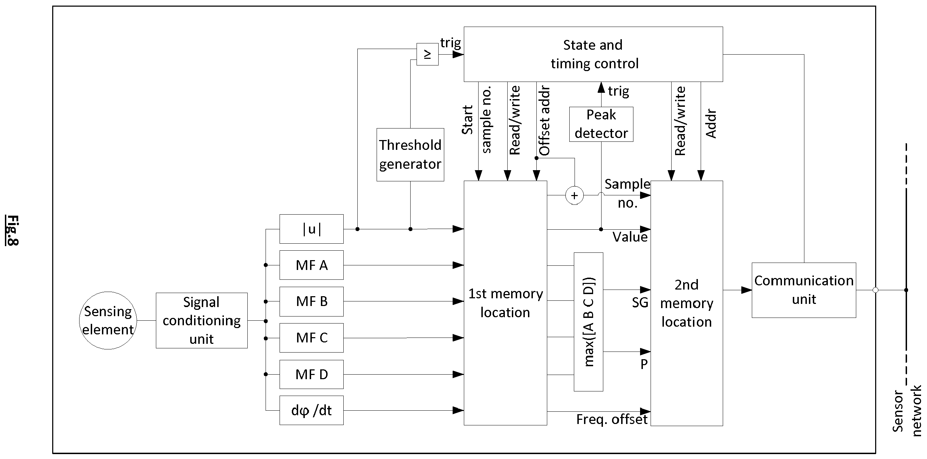

Fig.8 shows a device implementation adapted for executing the second example. Again some details of the data processing unit are shown. After conditioning the signal obtained by the sensing element, the magnitude information as physical quantity to be measured is first extracted by obtaining its absolute value. A comparator compares it with a threshold derived in a threshold generator from samples of the magnitude signal itself. When it equals or exceeds the threshold, the comparator output indicates that the condition for storing is fulfilled and triggers the state and timing control unit (see the flowchart of Fig.6). In addition to the device implementation of Fig.5, five additional physical quantities are derived in the data processing unit from the sensor signal conditioned by the signal conditioning unit. Four matched filters, indicated as MF A, MF B, MF C and MF D, provide a respective probability estimation of the sensor signal containing a signature A, B, C or D. The fifth additional physical quantity is the derivative of the phase of the conditioned sensor signal which indicates a frequency offset. These additional physical quantities are stored simultaneously to the magnitude information. Consequently, the magnitude, probabilities of signature A, B, C and D and the frequency offset of the conditioned sensor signal are stored in a first memory location as long as the second criterion is fulfilled. The condition for continued storage is derived and checked in the state and timing control unit, which also controls the memory access. Once the physical samples have been stored, the state and control unit controls the memory access in such a way that the stored magnitude values are played back to the block obtaining the mathematical characteristics. In this example this is done by using a peak detector. Once a local maximum or peak has been found, the state and timing control unit is triggered by the peak detector. This indicates the memory position in the first memory location containing the data set to be transferred to the second memory position. In order to save memory and network bandwidth the maximum among the stored probabilities of signatures A, B, C or D is derived in a maximum detector which provides the maximum probability P (means level of confidence) and the signature number SG containing the maximum (where e.g. 0 = signature A, 1 = signature B, 2 = signature C, 3 = signature D). The data set to be written to the second memory location is composed of related sample number, the magnitude value, the signature SG, the level of confidence P of the signature and the frequency offset. In this particular case only the start sample number is stored in the first memory, while the samples of the physical quantities are stored at incremental positions, the sample number to be stored in the second memory location is derived by summing the stored start sample number and the offset address provided by the state and timing control unit. The second memory location now contains the data sets shown in the lower part of Fig.7, which can be accessed by the communication unit for transferring over the sensor network.

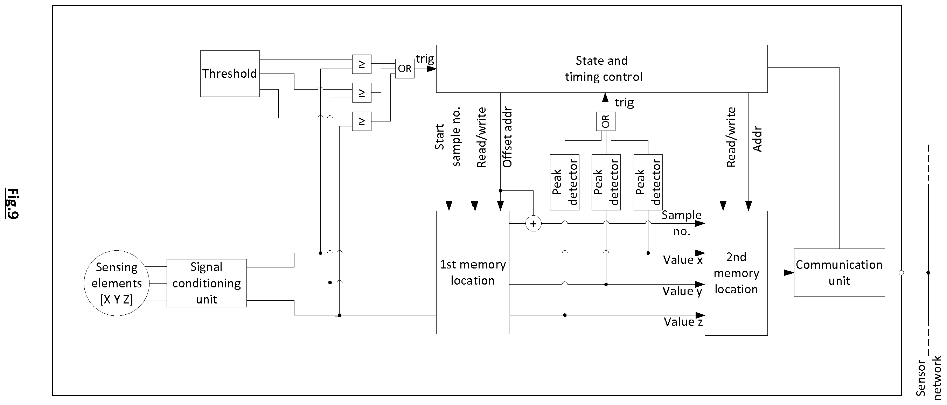

Another embodiment of a device according to the invention is shown in Fig.9, where the sensing elements deliver three independent physical quantities denoted X, Y and Z. Each physical quantity is conditioned separately and checked against the first criterion with a corresponding threshold derived in a threshold block. As soon as one of the physical quantities meets the first criterion, the values of all the physical quantities are stored simultaneously in a first memory location as long as the second criterion is fulfilled. The second criterion is evaluated in the state and timing control unit which also controls the memory access. Once the physical samples have been written to the first memory location, the state and control unit controls the memory access in such a way that the stored values are played back to the block obtaining the mathematical characteristics. This is done by means of three peak detectors in this embodiment. Once a local maximum or peak has been found in at least one of the three samples, the state and timing control unit is triggered by one or more of the peak detectors. This indicates the memory position in the first memory location containing the data set to be transferred to the second memory position. The second memory location now contains the data sets which can be accessed by the communication unit for transfer over the sensor network.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. Method for reducing an amount of measurement data, comprising :
- receiving a set of measurement data values of a physical quantity,
- for a first data value of said set checking if said first data value meets a condition for storing and if said condition for storing is met, storing said first data value in a memory,
- for each subsequent data value of said set, storing said subsequent data value as long as a condition for continued storage is met,
- performing a postprocessing operation on the data values stored in said memory,
- storing the postprocessed data values.

2. Method as in claim 1, wherein a calibration step is performed wherein said condition for storing and/or said condition for continued storage are programmed.

3. Method as in any of claims 1 to 2, wherein said condition for storing is a threshold.

4. Method as in claim 3, wherein said threshold is adaptable.

5. Method as in claim 4, wherein said adaptable threshold is dependent on data values of said physical quantity or of another physical quantity.

6. Method as in any of claims 1 or 2, wherein said condition for storing is a maximum number of consecutive data values not having met said condition for storing.

7. Method as in any of the previous claims, wherein said condition for continued storage indicates a fixed number of storable data values.

8. Method as in any of the previous claims, wherein said postprocessing operation comprises deriving at least one mathematical characteristic of said data values stored in said memory.

9. Method as in any of the previous claims, comprising a step of checking if a stop criterion is satisfied and if not, repeating the steps of claim 1.

10. Method as in any of the previous claims, comprising
- receiving an additional set of measurement data values of an additional physical quantity,
- when storing said first data value and said subsequent data values of said set of measurement data values, storing a corresponding first data value and corresponding subsequent data values of said additional set,
- taking into account said stored corresponding first data value and corresponding subsequent data values of said additional set, when performing said postprocessing operation.

11. Method as in claim 10, wherein said taking into account comprises a postprocessing on said corresponding data values of said additional set.

12. Method as in claim 10 or 11, wherein for said corresponding first data value of said additional set it is checked if said corresponding first data value meets an additional condition for storing and if said additional condition for storing is met, storing said first data value in a memory, and wherein for each corresponding subsequent data value of said additional set, said corresponding subsequent data value is stored as long as an additional condition for continued storage is met.

13. Method as in any of claims 10 to 12, wherein said additional condition for storing is the same as said condition for storing and/or wherein additional condition for continued storage is the same as said condition for continued storage.

14. Device for reducing an amount of measurement data, comprising a data processing unit arranged for
- receiving a set of measurement data values of a physical quantity,
- checking for a first data value of said set if said first data value meets a condition for storing and, if said condition for storing is met, forwarding said first data value for storage in a memory,
- forwarding for each subsequent data value of said set, said subsequent data value for storage in said memory as long as a condition for continued storage is met,
- performing a postprocessing operation on the data values stored in said memory,
- storing the postprocessed data values.

15. Device as in claim 14, comprising a communication unit arranged for reading out said postprocessed data values and applying said read out data to a sensor network.

16. Device as in claim 14 or 15, wherein said communication unit is arranged to receive via a network connection said condition for storing and/or said condition for continued storage and to forward it to said data processing unit.
